(19) Europäisches Patentamt
European Patent Office
Office européen des brevets

(11) **EP 1 793 488 A1**

(12) **EUROPEAN PATENT APPLICATION**

(43) Date of publication:
**06.06.2007 Bulletin 2007/23**

(51) Int Cl.:
*H03B 5/04* (2006.01)   *H03B 5/36* (2006.01)
*H03L 1/02* (2006.01)

(21) Application number: **05405677.5**

(22) Date of filing: **30.11.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **Microdul AG**
**8045 Zürich (CH)**

(72) Inventors:
 • **Thommen, Werner**
 **8003 Zürich (CH)**

 • **Poole, Philip John**
 **8874 Mühlehorn (CH)**
 • **Annen, Markus Erwin**
 **5400 Baden (CH)**

(74) Representative: **Liebetanz, Michael et al**
**Isler & Pedrazzini AG**
**Gotthardstrasse 53**
**Postfach 1772**
**8027 Zürich (CH)**

(54) **Device for frequency trimming of a crystal oscillator**

(57)     A device for frequency trimming of a crystal oscillator comprising a crystal oscillator, at least one capacitor ($C_{S2}$) to provide the necessary phase shift and an amplifier provided to maintain oscillation. A divider (305) connected with the crystal oscillator driven by the oscillator frequency signal ($f_{OSC}$) generates a divided oscillator frequency signal ($f_{OSC}/n$). A modulator (303) connected with the output of the divider (305) produces a modulated signal ($F_{MOD}$) based on said divided oscillator frequency signal ($f_{OSC}/n$). An additional switchable load capacitor ($C_{MOD}$) is capable of being switched in parallel with said at least one capacitor ($C_{S2}$) or in parallel with the crystal oscillator using said modulated signal ($F_{MOD}$) to control said switched load capacitor. This device achieves a simple solution for accurate jitter free trimming of a crystal oscillator, which can be readily integrated and used for various frequency control schemes, e.g. temperature compensation.

**Fig. 3**

**Description**

Field of the invention

The invention relates to a device for frequency trimming of a quartz-crystal oscillator, especially a device and method using frequency compensation based upon a switched capacitor.

Prior Art

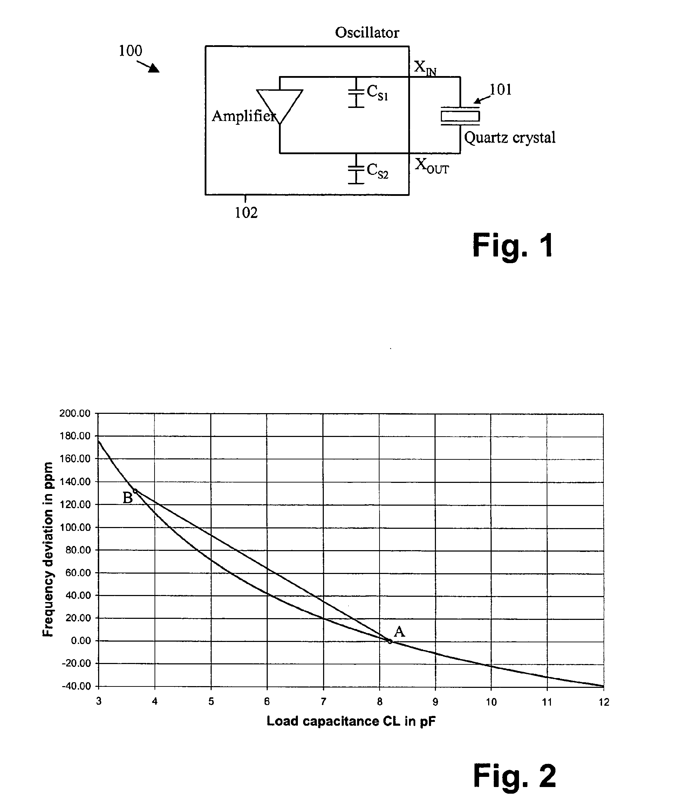

Figure 1 shows a common low frequency quartz oscillator circuit 100 according to prior art. This type of circuit could be used for a 32kHz watch oscillator for example. The operation of this circuit is generally known to the person skilled in the art. The piezoelectric effect of a quartz crystal cut to vibrate at a particular frequency is used as the electrical frequency reference. The quartz crystal is shown as element 101 in Figure 1. Capacitors $C_{S1}$ and $C_{S2}$ provide a defined load for the crystal and amplifier. The amplifier provides sufficient drive and feedback to maintain oscillation. The generalised circuit can be realised in different forms, for instance using discrete components or as an integrated circuit 102, but always uses a discrete quartz crystal.

The inherent production accuracy for the frequency of a quartz crystal is in the order of 10ppm. For many applications (e.g. watch circuits) better frequency accuracy is required. There are two well-known methods to trim the frequency to a desired value:

a) Analogue trimming: The frequency of the crystal is "pulled" by adding or subtracting a fixed load capacitance, i.e. changing the value of $C_{S1}$ or $C_{S2}$.

b) Digital trimming: A number of oscillator pulses are suppressed or added. For example, a system could be comprised of an oscillator and a divider. The divider is used to define the period ($T_{COR}$) over which the frequency correction takes place. The minimum correction period ($T_{COR}$) is equal to the oscillator period ($T_{OS}$) multiplied by the reciprocal of the desired frequency resolution.

$$T_{COR} = T_{OS} \cdot (1/\text{Resolution})$$

A desired resolution of 1ppm would give a period of $T_{COR} = T_{OS} \cdot 10^6$. All frequencies higher than $1/T_{COR}$ show considerable frequency jitter.

Digital trimming is especially suited to integrated circuits but if frequency jitter is not tolerable, analogue trimming is necessary. Analogue trimming is usually achieved by trimming a discrete capacitor, connecting a number of different (binary weighted) capacitors or by employing an element that changes its capacitance as a function of the applied voltage (varicap). Both of the methods above present difficulties for integration: the digital trimming method results in significant frequency jitter, the varicap is often incompatible with standard low voltage CMOS technology and using many capacitors has several disadvantages as given below:

-    Frequency is a non-linear function of the capacitance. The exact function is in part dependent on a particular quartz crystal and its load capacitance. Hence adjusting the frequency by increasing or reducing integrated load capacitance requires several set and measurement steps.
-    Using several capacitors is expensive in terms of silicon area and test time.
-    The manufacturing tolerances of the different binary weighted capacitors can cause inaccuracies in the binary step.

Summary of the invention

The system according to the present invention describes a device that is especially suited for integration but has considerably better (reduced) jitter when compared to the analogous or digital trimming method according to the state of the art. The frequency compensation function is linear and the advantage of this over other methods will be explained later.

Such a device for frequency trimming of a crystal oscillator comprises a quartz crystal oscillator, at least one capacitor to provide the necessary phase shift and an amplifier to maintain oscillation. Furthermore, said device comprises a divider connected to the quartz crystal oscillator driven by the oscillator frequency signal to generate a divided oscillator frequency signal; a modulator connected with the output of the divider to produce a modulated signal based on said divided oscillator frequency signal; and an additional switched load capacitor capable of being switched in parallel with said at least one capacitor or in parallel with the crystal oscillator using said modulated signal to control the switching operation of said switched load capacitor.

Said modulated signal may be any signal that is used for such a purpose. Preferably a pulse width modulated signal may be used. Furthermore it should be noted that the invention is not limited to a pulse width modulation scheme. Any modulation scheme that switches said load capacitor ($C_{MOD}$) in parallel with the load capacitance over a defined period of time can be used. For example a chopped square wave could be used.

This device achieves a simple solution for trimming a crystal oscillator, which can be readily integrated and used for various control schemes, e.g. temperature compensation and general quartz crystal frequency compensation.

Brief description of the drawings

The drawings will be explained in greater detail by means of a description of an exemplary embodiment, with reference to the following figures:

Fig. 1     shows a common low frequency quartz oscillator;
Fig. 2     shows the capacitance characteristics of the frequency of 32 kHz quartz crystal as a function of load capacitance;
Fig. 3     shows the trimming principle according to the invention;
Fig. 4     shows the pulse width modulation principle according to the invention;
Fig. 5     shows the temperature characteristics of the frequency of a 32 kHz quartz crystal; and
Fig. 6     shows the temperature compensation principle according to the invention.

Detailed description of the preferred embodiments

The frequency of a quartz crystal is not only dependent upon the particular cut it has and its temperature, but also upon the capacitive load applied to it (in broader terms, the impedance applied to it). A particular crystal is designed to operate with a specific load capacitance in order to produce a particular frequency. Using a load capacitance that is different from the specified load capacitance will cause the crystal to oscillate at a slightly different frequency. The frequency deviation for a 32kHz crystal designed to have a load capacitance of 8.2pF over a range of load capacitance is given in Figure 2. The normal working point (8.2pF) is indicated by the letter A. It is clear from Figure 2 that it is possible to change the frequency of the crystal by changing the load capacitance. The relationship between the oscillator frequency ($f_{CL}$) and the various capacitances is given below.

$$f_{CL} = f_S\left(1 + \frac{C_1}{2(C_0 + C_L)}\right)$$

$$C_L = \frac{C_{S1} \times C_{S2}}{C_{S1} + C_{S2}}$$

$f_{CL}$ =     Load dependent oscillator frequency
$f_S$ =     Resonant frequency
$C_0$ =     Static capacitance (quartz crystal)
$C_1$ =     Motional capacitance (quartz crystal)
$C_L$ =     Load capacitance
$C_{S1}$ =     Input load capacitor
$C_{S2}$ =     Output load capacitor

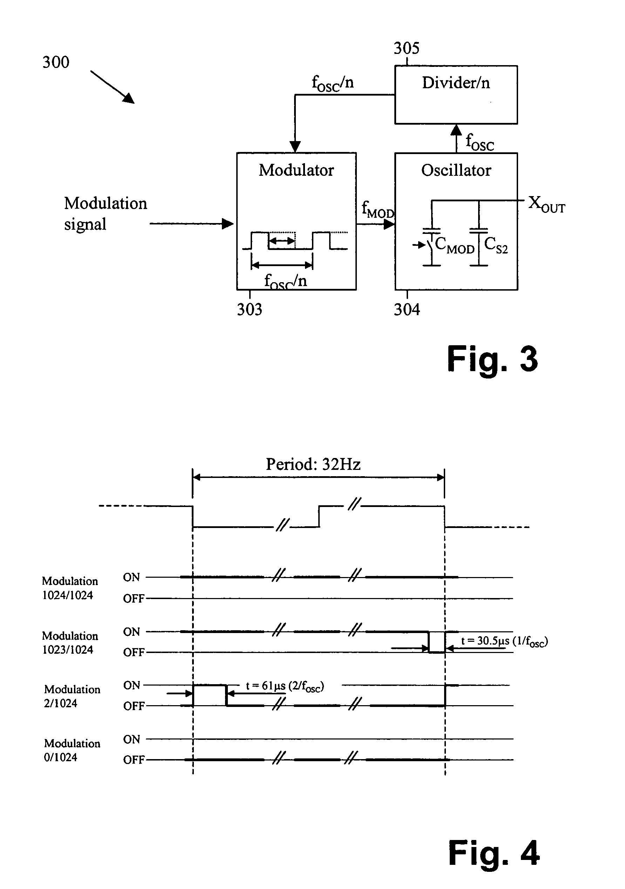

Figure 3 shows the trimming principle 300 according to the present invention. A modulation signal is fed into a modulator 303. The modulator 303 sets the pulse width within the period ($n/f_{OSC}$) and feeds the resulting signal $F_{MOD}$ into the oscillator block 304. The oscillator block 304 shows the oscillator connection to $X_{OUT}$. This can be compared to the generalised oscillator diagram given in Figure 1. The single load capacitor of $C_{S2}$ in Figure 1 is replaced by two capacitors $C_{S2}$ and $C_{MOD}$ in Figure 3. $C_{MOD}$ can be switched in parallel to $C_{S2}$ causing this part of the load capacitance to be $C_{S2}$ or $(C_{S2} + C_{MOD})$. At steady state, a load capacitance of $C_{S2}$ corresponds to a frequency given by the point designated by the letter B in Figure 2 and a load capacitance of $(C_{S2} + C_{MOD})$ results in a frequency given by said point A. If $C_{MOD}$ is periodically switched in parallel to $C_{S2}$ a frequency fX between fA and fB results. The frequency fX lies on the straight line between points A and B.

The crystal oscillator has a very high Q-factor and acts as an excellent low pass filter. This means that switching the load capacitance within a short period causes only a small frequency jitter (i.e. the frequency does not dynamically switch between fA and fB but rather between fX - $\Delta$x and fX + $\Delta$x where $\Delta$x is the frequency jitter). The frequency fX is a preferably linear function of the modulation (represented by the straight line between the points marked A and B in Figure 2). Although there is a slight frequency jitter of fX due to the variation $\Delta$x there is no jitter at the output frequency $f_{OSC}/n$ since each period $n/f_{OSC}$ will be corrected identically.

The method described in this invention has a much higher jitter free frequency for a given frequency resolution than the digital trimming method. For example, if the desired frequency resolution is 1ppm (1 part per million) then the highest jitter free frequency for the digital trimming frequency is:

$$T_{COR} = (T_{OS} . (1/Resolution))$$

$$For\ Tos = (1/32'768)s\ T_{COR} = 30.5s\ or\ 0.032Hz.$$

In the example above for the digital method, all frequencies above 0.032Hz suffer from jitter.

For the invention, the desired frequency resolution is dependent on the maximum frequency range over which the correction must take place and the number of steps used for pulse width modulation. Good results with a frequency resolution of 1ppm over a frequency range of approximately 200ppm can easily be achieved using 256 pulse width steps (see Figure 2). In general, if the number of steps is limited to multiples of $2^n$ then the maximum jitter free frequency is:

$$f_{JF} = f_{OSC}/(number\ of\ steps)$$

$$As\ an\ example:\ For\ 1ppm\ and\ 256\ steps\ f_{JF} = 128Hz$$

128Hz is 4000 times better than the digital method.

The method described in this invention allows the user to set frequency fX accurately using a specific pulse width value once the frequencies marked at points A and B in Figure 2 corresponding to capacitive loads $C_L$ and $C_L + C_{MOD}$ are known. For example, to obtain a frequency fX = fA + (fB -fA)/2, the pulse width may simply be set to half the period. The frequency fX is linearly related to the pulse width as follows:

$$fX = fA + ((fB-fA) . PW)$$

where PW is the pulse width expressed as a fraction of the period.

The method described in this invention can be compared to the method of selecting several different values of load capacitance where a particular frequency (fX) is obtained by switching in a specific set of load capacitors. A specific set of load capacitors is equivalent to a specific capacitance value $C_L$. With respect to Figure 2, the frequency can be determined by the non-linear curve depicting the relationship between the load capacitance $C_L$ and the frequency. The disadvantage is that this curve is not only non-linear but that the non-linearity is dependent on particular crystal characteristics. This means that it is not possible to simply set a middle frequency once two extreme frequencies are known. An iterative approach must be taken instead.

It will be obvious to a person skilled in the art that the location of the modulating capacitor is not restricted solely to the location of $C_{S2}$. The modulating capacitor can also be located in parallel to $C_{S1}$ or in parallel to the crystal.

The oscillator 304 provides a signal $f_{OSC}$ to the divider 305. The divider then divides the signal $f_{OSC}$ in order to feed it into the modulator 303.

Preferably the divider (305) generates a divided oscillator frequency signal ($f_{OSC}$/n) with a predetermined division factor (n).

A typical pulse width modulation scheme for a 32kHz watch crystal oscillator frequency trimming, using the method described above, is given in Figure 4. The capacitor $C_{MOD}$ is switched in parallel to capacitor $C_{S2}$ during the time when the modulation pulse is high as shown in the diagram. The modulation scheme uses n=1024 and is shown with modulation values of 0, 2, 1023 and 1024. It is obvious to the person skilled in the art that other modulation schemes can be used to achieve a similar result and that the idea expressed in this patent includes such variations.

The ability to trim the oscillator frequency with low jitter using an integrated circuit can be used to compensate frequency deviations encountered from various sources including but not limited to manufacturing, temperature and ageing.

As an example, the compensation of frequency over a temperature range for a 32kHz crystal oscillator will now be described.

As already known, the frequency behaviour of a quartz crystal over temperature can be approximated by a quadratic function of the form:

$$\Delta f = a(T - T_0)^2$$

$T_0 =$   Turnover temperature, the frequency at which there is no deviation due to temperature (typically about 25°C for a 32kHz quartz crystal)

$T =$   Temperature

$a =$   slope factor (typically about -0.035 ppm /°C$^2$)

$\Delta f =$   Difference in frequency between frequency at temperature $T_0$ and the frequency at temperature T.

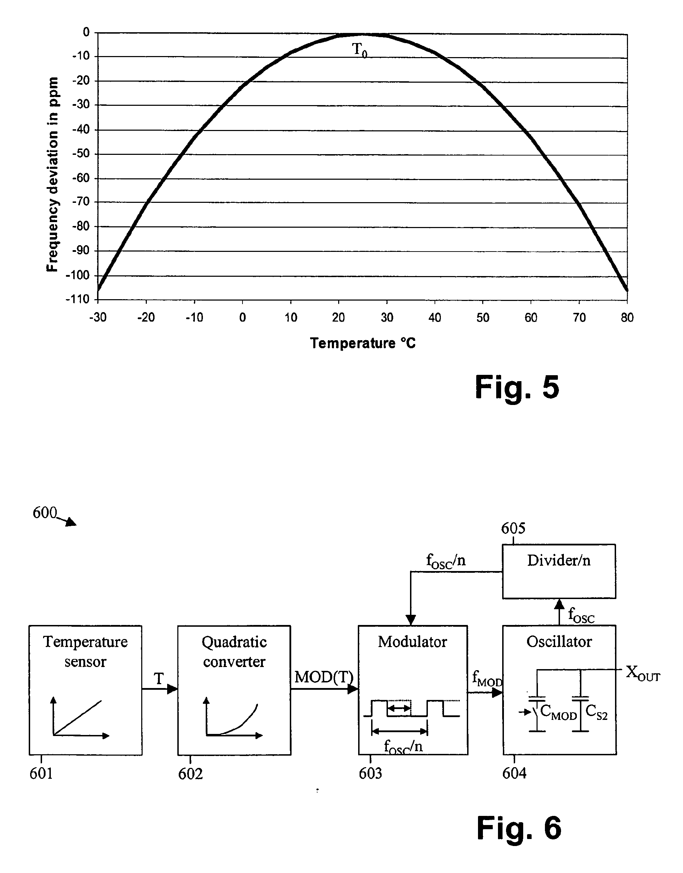

Figure 5 shows the typical frequency deviation with temperature for a 32kHz quartz crystal. It can be seen that the frequency deviation is close to 0ppm if the temperature is between 20°C and 30°C. If the temperature is out of this range, the frequency deviation will increase.

A further embodiment of the present invention tackling the problem shown in Figure 5 is disclosed in connection with Figure 6. A temperature sensor 601 detects the temperature of the device and generates a signal T. Therefore signal T is initially linearly dependent on the temperature. The signal is then fed into a quadratic converter 602. The signal T is processed by the quadratic converter 602, which means that the output signal of converter 602, signal MOD (T), is dependent on the square of the temperature signal. MOD(T) is then fed into the modulator 603 which can be identical to the modulator 303 as illustrated in Figure 3. The fixed, preferentially predetermined, period ($f_{OSC}$/n), over which $C_{MOD}$ can be switched, is derived from the oscillator frequency itself using the divider 605.

The duty cycle controlling the time that $C_{MOD}$ is actually switched into the circuit is given by signal MOD(T) and implemented in the modulator block 603.

The resulting crystal oscillator frequency can thus be trimmed using the system 600 in Figure 6 to remain relatively constant over the temperature range.

It is understood to the person skilled in the art that other modulated signals such as the described pulse width modulated signal may also be used. Very good results were also achieved by a chopped square wave signal.

**Claims**

**1.** Device for frequency trimming of a crystal oscillator comprising a quartz crystal oscillator (101), at least one capacitor ($C_{S1}$, $C_{S2}$) to provide the necessary phase shift and an amplifier provided to maintain oscillation, **characterised in that** said device further comprises

- a divider (305) connected with the crystal oscillator driven by the oscillator frequency signal ($f_{OSC}$) to generate a divided oscillator frequency signal ($f_{OSC}$/n);
- a modulator (303) connected with the output of the divider (305) to produce a modulated signal ($F_{MOD}$) based on said divided oscillator frequency signal ($f_{OSC}$/n);
- an additional switched load capacitor ($C_{MOD}$) capable of being switched in parallel with said at least one capacitor ($C_{S1}$, $C_{S2}$) or in parallel with the crystal oscillator (101), using said modulated signal ($F_{MOD}$) to control the switching operation of said switched load capacitor ($C_{MOD}$).

**2.** Device according to claim 1, **characterised in that** the modulated signal is a pulse width modulated signal or any other modulated signal that switches said load capacitor $C_{MOD}$ in parallel with the load capacitance over a defined period of time during a predefined interval, such as a chopped square wave signal.

3.  Device according to claim 1, **characterised in that** the crystal oscillator (101) is a temperature compensated 32kHz crystal oscillator and further comprising

    - a temperature sensor (601) to produce a temperature signal (T) that is linearly related to the temperature of the oscillator (101); and
    - a quadratic converter (602) to produce a signal (MOD(T))dependent on the square of said temperature used as input signal for said modulator (303).

4.  Device according to one of claims 1 to 3, **characterised in that** the system is arranged for the use in any type of frequency trimming in conjunction with a quartz-crystal oscillator.

5.  Device according to one of claims 1 to 4, **characterised in that** the system is arranged for the use in a watch or in real time clock applications.

**Fig. 1**

**Fig. 2**

300

305

$f_{OSC}/n$

Divider/n

$f_{OSC}$

Modulation
signal

Modulator

$f_{MOD}$

Oscillator

$X_{OUT}$

$C_{MOD}$ $C_{S2}$

$f_{OSC}/n$

303

304

## Fig. 3

Period: 32Hz

Modulation
1024/1024

ON

OFF

Modulation
1023/1024

ON

OFF

$t = 30.5\mu s \ (1/f_{OSC})$

Modulation
2/1024

ON

OFF

$t = 61\mu s \ (2/f_{OSC})$

Modulation
0/1024

ON

OFF

## Fig. 4

Fig. 5

Fig. 6

**European Patent Office**

## EUROPEAN SEARCH REPORT

Application Number

EP 05 40 5677

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 583 059 A (KONNO ET AL) 15 April 1986 (1986-04-15) * the whole document * ----- | 1-5 | H03B5/04 H03B5/36 H03L1/02 |
| X | US 4 730 286 A (AIZAWA ET AL) 8 March 1988 (1988-03-08) * the whole document * ----- | 1,2,4,5 | |

TECHNICAL FIELDS
SEARCHED    (IPC)

H03B
H03L

The present search report has been drawn up for all claims

| Place of search | Date of completion of the search | Examiner |
|---|---|---|
| The Hague | 17 January 2006 | Beasley-Suffolk, D |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 05 40 5677

This annex lists the patent family members relating to the patent documents cited in the above-mentioned European search report.
The members are as contained in the European Patent Office EDP file on
The European Patent Office is in no way liable for these particulars which are merely given for the purpose of information.

17-01-2006

| Patent document cited in search report | | Publication date | Patent family member(s) | | Publication date |
|---|---|---|---|---|---|
| US 4583059 | A | 15-04-1986 | DE | 3036785 A1 | 16-04-1981 |
| | | | FR | 2466899 A1 | 10-04-1981 |
| | | | GB | 2063603 A | 03-06-1981 |
| | | | HK | 56785 A | 09-08-1985 |
| | | | SG | 33385 G | 02-05-1986 |
| US 4730286 | A | 08-03-1988 | CH | 664252 A | 29-02-1988 |
| | | | GB | 2163575 A | 26-02-1986 |
| | | | HK | 78989 A | 13-10-1989 |

EPO FORM P0459

For more details about this annex : see Official Journal of the European Patent Office, No. 12/82